# EUROPÄISCHE PATENTSCHRIFT

(11) **EP 1 445 792 B1**
(45) Veröffentlichungstag und Bekanntmachung des Hinweises auf die Patenterteilung: **03.09.2008**
(21) Anmeldenummer: 04001552.1
(22) Anmeldetag: 26.01.2004
(51) Int. Cl.: H01L 21/68

(54) **Vorrichtung zum Handhaben von Platten**
Plate manipulation device
Dispositif de manipulation de plaques

(30) Priorität: 04.02.2003 DE 10304425
(43) Veröffentlichungstag der Anmeldung: 11.08.2004
(73) Patentinhaber: Infineon Technologies AG, 81669 München (DE)
(72) Erfinder: Aigner, Kurt, Dr., 9073 Viktring (AT); Binder, Alfred, 9023 Landskron (AT); Matschitsch, Martin, 9181 Feistritz i. Ros (AT); Michenthaler, Norbert, 9530 Bad Bleiberg (AT); Kroupa, Gerhard, 9500 Villach (AT); Pucher, Gerhard, 9500 Villach (AT)
(74) Vertreter: Kindermann, Peter

(56) Entgegenhaltungen:
- EP-A- 0 924 148
- EP-A- 1 091 389
- EP-A- 1 294 014

## Beschreibung

Die vorliegende Erfindung betrifft eine Vorrichtung zum Handling von Platten, insbesondere von Halbleiterscheiben, die an einem ersten Ort aufzunehmen und ihrer Lage zu verändern oder zu einem zweiten Ort zu transportieren sind.

Halbleiterscheiben oder -wafer sind bekanntlich sehr dünn und weisen bei einem Durchmesser in der Größenordnung von 2 bis 8 Zoll Scheibendicken auf, die in der Größenordnung von einigen 10 bis einigen 100 µm liegen. Solche Halbleiterscheiben werden bisher zumeist manuell bzw. mit einem Handlingsystem von einem ersten Prozessierungsort zu einem zweiten Prozessierungsort gebracht. Dazu muss ihre Position auf dem Handlingsystem manchmal verändert, beispielsweise gedreht werden. Beim Stand der Technik muss dazu der Wafer manuell berührt, vom Handlingsystem abgehoben, durch die Hand des Bedienungspersonals über den gewünschten Winkel gedreht und zurück auf das Handlingsystem gelegt werden. Dies erfordert wegen der begrenzten Drehbarkeit der Hand häufig ein Nachgreifen, manchmal sogar mehrfach, so dass die Handhabung problematisch bleibt.

In der Praxis werden durch das Dünnschleifen ungewollt oft verbogene Halbleiterscheiben erzeugt, die sowohl konkave als auch konvexe Krümmungen enthalten. Diese Halbleiterscheiben können durch das Handlingsystem nicht mehr problemfrei gehandhabt werden. Daher werden sie im allgemeinen manuell mit Hilfe einer Pinzette aus einem entsprechenden Behälter entnommen und zur weiteren Prozessierung beispielsweise in ein so genanntes Quarz-Boot gebracht. Ein Quarz-Boot ist eine bestimmte Aufbewahrungskassette für Halbleiterscheiben. Der Einsatz einer Pinzette ist aber nicht unproblematisch, da dieser leicht zu teilweisen Beschädigungen, wie der Entstehung von Haarrissen und damit zu einem Ausfall von Chips in dem entsprechenden Bereich der Halbleiterscheibe führen kann.

Das Entnehmen und Einfügen von mechanisch wenig belastbaren Wafern aus oder in Materialträger (die bereits genannten Quarz-Boote, Kunststoffhorden o. ä.)muss zudem ohne Kantenkontakt mit diesen Behältern erfolgen, da bei Kantenkontakt sowohl die dünnen Wafer als auch die Behälter beschädigt würden, denn derartig dünne Wafer sind Rasierklingen ähnlich scharf.

Durch punktuelle Aufnahme mittels herkömmlicher Pinzetten ist der dünne Wafer nicht ausreichend unterstützt. Daher neigt ein so gehandhabter Wafer über die bereits erwähnten Probleme hinaus leicht zum Schwingen. Die Waferverbiegung hervorgerufen durch Verspannung des Wafers erschwert die Be- und Entstückung für den Operator. Die scharfen Kanten der Wafer schneiden in den schmalen Schlitzen der Behälter in die Materialstege und das führt unweigerlich zum Bruch des Wafers und zu Beschädigungen am Behälter.

Aus der DE 199 48 572 A1 ist eine so genannte pneumatische Pinzette zur Handhabung von Dünnwafern bekannt. Die dort gezeigte und beschriebene Pinzette weist einen als Düsenplatte ausgebildeten Teller auf, welcher in seinem Zentrum eine Vakuumbohrung aufweist, und der am Umfang zahlreiche Düsenbohrungen enthält, die zur Erzeugung eines so genannten Bernoulli-Prinzips dienen, welches auch als Bernoulli-Effekt bekannt ist. Unter diesem Bernoulli-Effekt ist die Bildung eines hydrodynamischen Unterdrucks zu verstehen, welcher dadurch entsteht, dass aus dem Zentrum einer Düsenplatte Gas durch nach außen gerichtete Düsen in die Randbereiche der Düsenplatte strömt und dabei im Zentrum ein geringerer Luftdruck herrscht, als in den Außenbereichen, in welche das Gas vom Zentrum aus strömt. Dünne Waferscheiben können mit einer derartigen pneumatischen Pinzette, deren Funktion auf dem vorbeschriebenen Effekt beruht, verhältnismäßig gut gehandhabt werden, da die Kombination von Bernoulli-Effekt und Vakuum als berührungslose Halteelemente für Waferscheiben entscheidende Vorteile hat. Aber eine Umsetzung des Wafers bezüglich seiner Drehposition auf dem Handlingsystem ist auch mit einer derartigen Pinzette nicht ohne die eingangs genannte Problematik möglich.

Demgegenüber ist es Aufgabe der vorliegenden Erfindung, eine Vorrichtung zum Handling von Platten, beispielsweise Halbleiterscheiben zu schaffen, die ein sicheres Handhaben wie beispielsweise Transportieren, Positionieren und Ausrichten der Halbleiterscheiben, wie beispielsweise eine Be- und Entstückung in bzw. aus Behältern erlaubt, wobei die Vorrichtung eine möglichst geringe Masse aufweisen soll, um optimal bedient werden zu können. Ferner soll die überdeckte Fläche des zu handhabenden Wafers möglichst gering sein, damit sich weniger Fremdpartikel zwischen Halterung und Wafer einschleichen können. Außerdem soll der zu handhabende Wafer auch von seiner Rückseite einer optischen Kontrolle unterzogen werden können.

Diese Aufgabe wird bei einer Vorrichtung der eingangs genannten Art erfindungsgemäß durch eine Haltevorrichtung gelöst, deren Merkmale dem Anspruch 1 zu entnehmen sind. Vorteilhafte Ausgestaltungen der Haltevorrichtung sind den abhängigen Ansprüchen zu entnehmen.

Vorzugsweise weist die Haltevorrichtung zum hydrodynamischen Halten der Halbleiterscheibe ein Zentrum auf, das von einer Aufnahmevorrichtung gebildet wird, welche um ihre Mittelachse drehbar in der Haltevorrichtung gelagert ist.

Besonders vorteilhaft ist es, wenn das Zentrum von einer Aufnahmevorrichtung gebildet wird, deren Drehung mittels eines Antriebs erfolgt.

Weiter ist es vorteilhaft, wenn der Antrieb als Seilrollenantrieb ausgebildet und durch ein Handrad manuell betätigbar ist.

Ebenso ist eine vorteilhafte Haltevorrichtung realisierbar, wenn der Antrieb als fluidischer Antrieb ausgebildet ist und wenn der fluidische Antrieb durch ein Handrad steuerbar ist.

Ferner ist eine vorteilhafte Haltevorrichtung realisierbar, wenn der Antrieb als elektrischer Antrieb ausgebildet ist und wenn der elektrische Antrieb von einem Handrad steuerbar ist.

Darüber hinaus ist es von Vorteil, wenn die Aufnahmevorrichtung zumindest Düsenbohrungen zum Erzeugen eines hydrodynamischen Unterdrucks aufweist, wobei vom Zentrum sternförmig nach außen weisende Stützarme vorhanden sind, welche die zu handhabende Halbleiterscheibe zumindest in deren Außenbereich abstützen.

Auf diese Weise erhält man eine besonders vorteilhafte Vorrichtung, bei der mittels einer besonders:filigranen Ausführungsform ein hydrodynamischer Unterdruck zwischen Haltevorrichtung und Halbleiterscheibe erzeugt wird und bei der wenigstens eine Saugbohrung zum zusätzlichen Ansaugen der Halbleiterscheibe durch Vakuum dient.

Besonders vorteilhaft ist es, wenn ein Druckknopf ein Ventil derart beaufschlagt, dass bei einer einmaliger Druckknopfbetätigung die Vakuumposition aktiviert ist, bei nochmaliger Betätigung das Vakuum abgeschaltet und der Druckknopf wieder in der Ausgangsposition ist.

Die erfindungsgemäße Haltevorrichtung nutzt also sowohl den Bernoulli-Effekt zur Erzeugung eines hydrodynamischen Unterdrucks zwischen Haltevorrichtung und Halbleiterscheibe als auch ein gleichzeitiges Ansaugen durch eine Saugbohrung, die sich vorzugsweise im Zentrum der Haltevorrichtung befindet, aus, um die Halbleiterscheibe praktisch berührungsfrei an der Haltevorrichtung "haften" zu lassen, so dass sie sicher und zuverlässig transportiert und gehandhabt werden kann. Im Sinne der Erfindung lässt sich die Halbleiterscheibe exakt positionieren und drehen, bis sich ihre Markierung in Form einer Abflachung am Umfang, des so genannten Flaters, in der Sollposition befindet. Zerstörungen oder Beschädigungen der Halbleiterscheibe sind weder beim Drehen, noch beim Transportieren, noch bei anderen Handlingaufgaben zu befürchten, da diese von der Haltevorrichtung durch eine dünne Luftströmung weitestgehend getrennt ist. Damit kann die Halbleiterscheibe zerstörungs- und beschädigungsfrei manuell oder auch automatisch gedreht, transportiert und gehandhabt werden.

Weiterhin erfolgt eine weitgehende Planarisierung der Halbleiterscheibe infolge des hydrodynamischen Unterdruckes zwischen der Haltevorrichtung und der Halbleiterscheibe, so dass diese keine konkaven oder konvexen Krümmungen mehr aufweist, solange sie mit der erfindungsgemäßen Haltevorrichtung gedreht und/oder transportiert wird bzw. an dieser angebracht ist.

Dazu weist die Haltevorrichtung an den Endbereichen ihrer Stützarme Aufnahmekuppen auf, in denen Bohrungen zum Ansaugen der Halbleiterscheibe vorhanden sind.

Von besonderem Vorteil ist es, dass die Aufnahmekuppen der Haltevorrichtung kreisförmig und ballig ausgebildet sind.

Darüber hinaus ist es bei der Handhabung bestimmter Halbleiterscheiben von Vorteil, wenn die Aufnahmekuppen der Haltevorrichtung durch kreisringförmige Abschnitte gebildet werden, welche eine konvexe Oberflächengestaltung aufweisen.

Ferner kann es von Vorteil sein, wenn die Stützarme an ihren Endbereichen mittels eines Ringes miteinander verbunden sind, da diese Bauform die Neigung zu Schwingungen reduziert..

Wenn in dem Ring Ansaugöffnungen angeordnet sind, kann eine Halbleiterscheibe an ihrem Umfang stabil fixiert werden.

Von Vorteil ist es ebenfalls, wenn an den Stützarmen außerhalb der Endbereiche zusätzliche Stützelemente für die Halbleiterscheibe vorgesehen sind.

Da die Haltevorrichtung über einen Handgriff verfügt, durch welchen die Anschlüsse für die Gasversorgung und das Vakuum geführt werden, lässt sich die Haltevorrichtung sehr einfach an die Versorgungsnetze anstecken, wobei es besonders vorteilhaft ist, dass die Haltevorrichtung und der Handgriff trennbar ausgeführt sind, um einen eventuell notwendigen Austausch leicht vornehmen zu können.

Die Erzeugung des hydrodynamischen Unterdrucks zwischen der Haltevorrichtung und der Halbleiterscheibe durch die aus den Düsenbohrungen der Haltevorrichtung strömende Luft einerseits und die Erzeugung des Saugdrucks durch Ansaugen von Luft durch die Saugbohrung andererseits sind vorzugsweise getrennt steuerbar. Es ist also möglich, die erfindungsgemäße Haltevorrichtung zeitweise nur über den durch die Haltevorrichtung gelieferten Unterdruck und zeitweise nur über den durch die Saugbohrung erzeugten Saugdruck zu betreiben.

Die erfindungsgemäße Haltevorrichtung kann extrem dünn mit einer Bauhöhe von nur etwa 2 bis 4 mm ausgebildet werden. Damit ist es möglich, mit der Haltevorrichtung zwischen zwei übereinander in einer Horde liegenden Halbleiterscheiben einzugreifen und eine dieser Halbleiterscheiben aufzunehmen und gegebenenfalls zu drehen, bis sie sich in ihrer Sollposition befindet.

In einer möglichen Weiterbildung der Erfindung ist vorgesehen, dass auch im Randbereich der Haltevorrichtung, nämlich an den Enden der Stützarme zusätzliche Saugbohrungen vorgesehen sind. Haltevorrichtungen, die derartige zusätzliche Saugbohrungen im Endbereich der Stützarme aufweisen, haben sich als besonders vorteilhaft zum Bestücken von Quarzbooten mit Halbleiterscheiben erwiesen.

Wesentlich an der vorliegenden Erfindung ist also die gemeinsame Verwendung des nach Bernoulli erzeugten hydrodynamischen Unterdruckes, der ein "Haften" zwischen Halbleiterscheibe und Haltevorrichtung bewirkt, aber eine Drehung der Halbleiterscheibe ohne manuelle Berührung ermöglicht. Wobei wenigstens eine Saugbohrung zur Erzeugung des Vakuums andererseits die besonders filigrane Bauweise unterstützt und das Handling der zu haltenden Halbleiterscheibe noch erleichtert sowie eine deutlich verbesserte visuelle Kontrolle der Halbleiterscheibe ermöglicht.

Mit Hilfe von Ausführungsbeispielen wird die Erfindung anhand der Zeichnungen näher erläutert

Es zeigen:
Figur 1 eine schematische Darstellung einer erfindungsgemäßen Haltevorrichtung;
Figur 2 einen vergrößerten Ausschnitt einer Haltevorrichtung mit detailliert dargestelltem Antrieb;
Figur 3 eine variierte Einzelheit einer Vorrichtung gemäß Figur 1;
Figur 4 eine weitere Variante und
Figur 5 eine zusätzliche Variante.

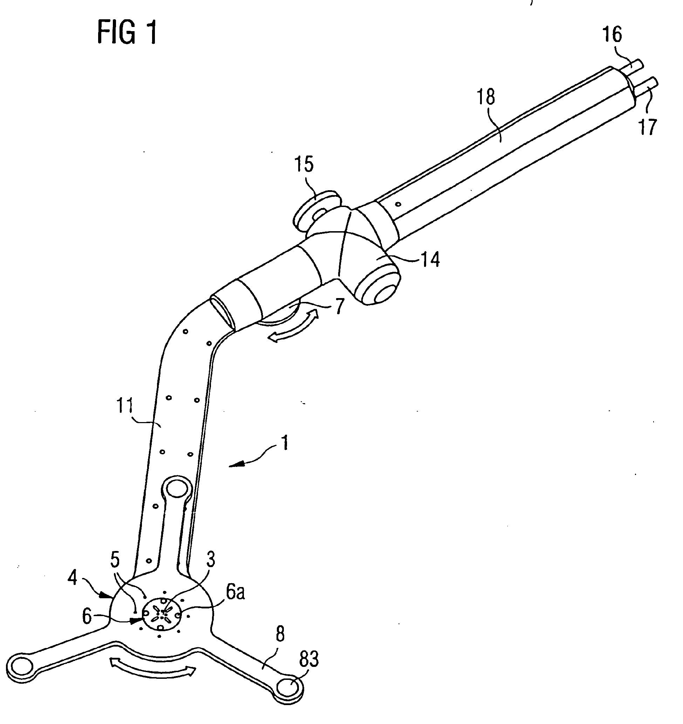

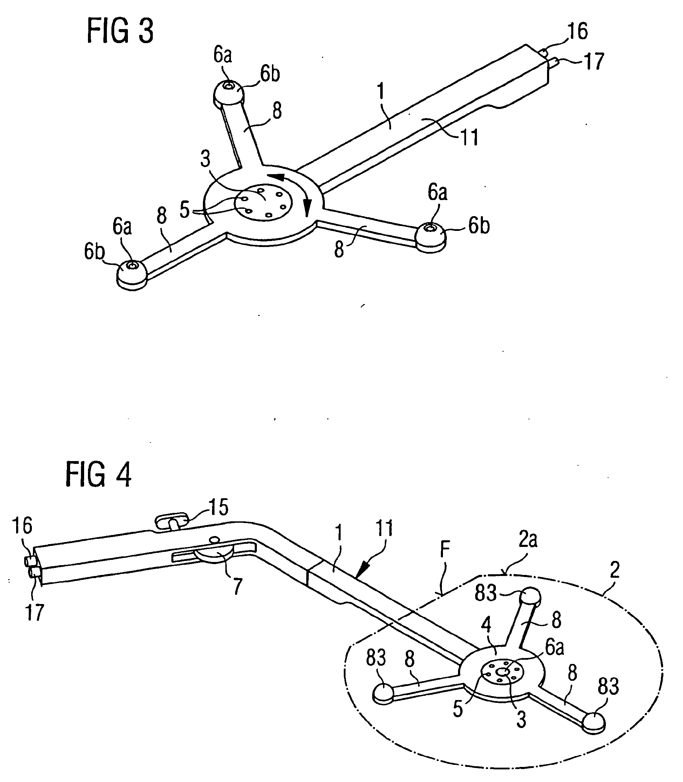

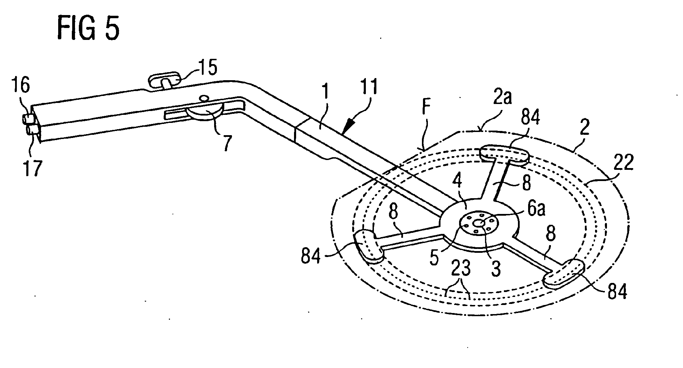

Die Darstellung in Figur 1 zeigt eine erfindungsgemäße Vorrichtung, die von einer Haltevorrichtung 1 zur Halterung von Halbleiterscheiben 2 gebildet wird. Die Halbleiterscheiben 2 sind in Figur 1 noch nicht dargestellt, sondern erst in den Figuren 4 und 5. Als Zentrum 3 der Haltevorrichtung 1 fungiert eine Aufnahmevorrichtung 4 mit einer Vielzahl von Düsenbohrungen 5, durch welche Gas ausströmen kann. Die Düsenbohrungen 5 sind um einen zentrischen Vakuum-Pad 6 herum angeordnet und unter einem Winkel zur Oberfläche des Zentrums 3 so geneigt, dass das ausströmende Gas von Zentrum 3 weg in die Außenbereiche der Aufnahmevorrichtung 4 strömen kann. Dadurch entsteht im Zentrum 3 der Aufnahmevorrichtung 4 ein gewisser Unterdruck, welcher als hydrodynamischer Unterdruck bezeichnet wird und den so genannten Bernoulli-Effekt hervorruft. Eine auf der Aufnahmevorrichtung 4 befindliche Halbleiterscheibe 2 wird durch diesen Bernoulli-Effekt praktisch berührungslos in der Schwebe über der Haltevorrichtung 1 gehalten.

Um eine laterale Verschiebung der Halbleiterscheibe 2 auf der Aufnahmevorrichtung 4 zu verhindern, sind Ansaugbohrungen 6a in dem Vakuum-Pad 6 angeordnet. Diese Ansaugbohrungen 6a sind mit einer nicht dargestellten Unterdruckquelle verbunden und erzeugen ein gewisses Vakuum, welches die durch den Bernoulli-Effekt in der Schwebe gehaltene Halbleiterscheibe 2 in gewissem Maße fixiert.

Die Aufnahmevorrichtung 4 ist in der Haltevorrichtung 1 drehbar gelagert, so dass sich die auf ihr befindliche Halbleiterscheibe 2 zusammen mit der Aufnahmevorrichtung 4 ebenfalls drehen lässt. Um die Aufnahmevorrichtung 4 drehen zu können, ist ein Handrad 7 vorgesehen, welches sich manuell mittels eines Fingers einer Bedienungsperson betätigen lässt und mittels eines noch näher zu beschreibenden Antriebs die Aufnahmevorrichtung 4 dreht.

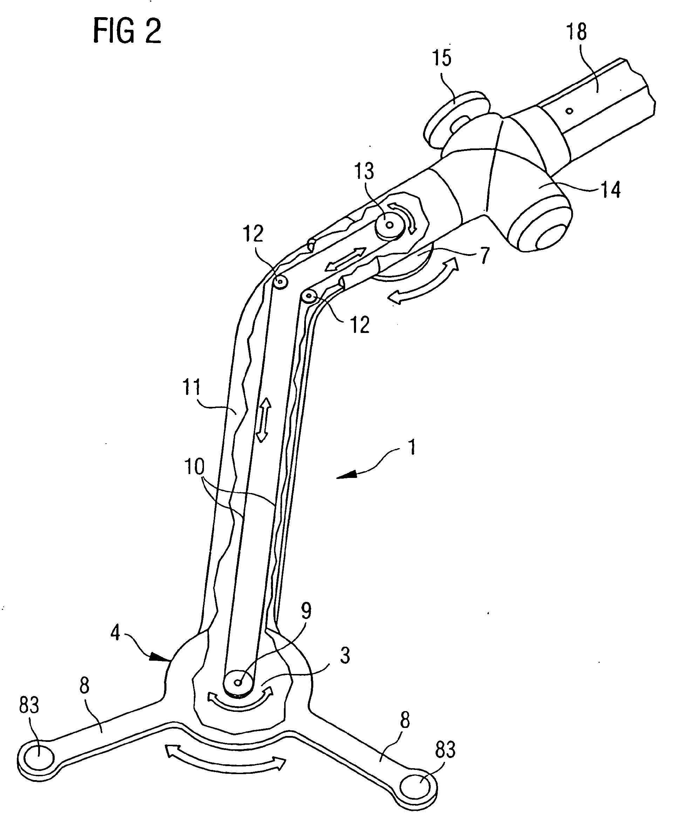

In Figur 2 sind Einzelheiten vergrößert dargestellt. Die Aufnahmevorrichtung 4 weist Stützarme 8 auf, deren Endbereiche Aufnahmekuppen 83 zur Aufnahme von Halbleiterscheiben 2 tragen. Die Aufnahmevorrichtung 4 ist drehbar in der Haltevorrichtung 1 gelagert und verfügt über ein Mitnahmerädchen 9, um welches ein Feinseil 10 gespannt ist. Das Feinseil 10 verläuft innerhalb eines zur Haltevorrichtung 1 gehörenden Trägers 11 in dem auch die Aufnahmevorrichtung 4 drehbar gelagert ist. Im Träger 11 sind Umlenkrollen 12 zur Umlenkung des Feinseils 10 angeordnet, mittels derer das Feinseil 10 sowohl umgelenkt als auch gespannt wird. Das Feinseil 10 umschlingt ferner ein Antriebsrädchen 13, das mit dem Handrad 7 in Wirkverbindung steht - zum Beispiel auf einer gemeinsamen Achse mit diesem angeordnet ist -, dadurch das Feinseil 10 bewegt und über das Mitnahmerädchen 9 die Aufnahmevorrichtung 4 dreht. In der Haltevorrichtung 1 befindet sich ferner ein Steuerventil 14 für die Beeinflussung der Zufuhr des Gases, welches den Bernoullieffekt erzeugt und zur Steuerung des Vakuums. Dieses Steuerventil 14 kann über einen Druckknopf 15 von einem Finger einer Hand einer Bedienungsperson betätigt werden. Die Bedienungsperson kann also mit einer Hand sowohl die Halbleiterscheibe 2 drehen, als auch die Zuführung des Bernoulligases und das Vakuum steuern. Der Druckknopf 15 mit dem Ventil 14 zum Ansteuern von Bernoullieffekt und Vakuum ist so ausgeführt dass er bei einmaliger Betätigung in der Vakuumposition einrastet. Dadurch ist die Hand der Bedienungsperson frei für die Betätigung des Handrads 7 zur Korrektur der Position der Abflachung 2a. Bei nochmaliger Betätigung wird das Vakuum gelöst, der Wafer 2 losgelassen und der Druckknopf 15 ist wieder in der Ausgangsposition.

Der gezeigte Antrieb über Rädchen 9, 12, 13 und Feinseil 10 ist nur ein bevorzugtes Ausführungsbeispiel und der Fachmann kann bei Bedarf den Antrieb auch anders gestalten. So ist ein fluidischer (pneumatisch oder hydraulisch) Antrieb ebenso vorstellbar, wie ein elektrischer, wobei die Steuerungsmöglichkeiten durch die Bedienungsperson erhalten bleibt.

In Figur 3 ist ein weiteres Ausführungsbeispiel dargestellt, bei dem die geometrische Anordnung der Bernoullidüsen und der Vakuumbohrungen vom bereits gezeigten Ausführungsbeispiel abweichen, ohne die Lehre der Erfindung zu verlassen. Die in diesem Ausführungsbeispiel gezeigte Aufnahmevorrichtung 4 mit Ansaugbohrungen 6a in den Endbereichen 6b der Stützarme 8 ist nur eine weitere Möglichkeit, Ansaugbohrungen 6a vorzusehen. Diese Ausführungsform ist realisierbar, weicht allerdings von dem ersten Ausführungsbeispiel ab, bei dem sich Ansaugbohrungen 6a eines Vakuum-Pads 6 im Zentrum 3 der Aufnahmevorrichtung 4 befinden. In jenem Fall, der dem Ausführungsbeispiel in den Figuren 1 und 2 entspricht, welches in der Praxis auch bevorzugt wird, können die Ansaugbohrungen in den Endbereichen der Stützarme 8 natürlich entfallen. Bei der Erfindung sind die Stützarme 8 der drehbaren Aufnahmevorrichtung 4 von besonderer Bedeutung, denn durch diese filigrane Ausführung können die Halbleiterscheiben 2 genauso gehalten werden, wie bei einer vollständig geschlossenen Düsenplatte gemäß dem Stand der Technik, dort deckt jedoch die Düsenplatte die zu haltende Halbleiterscheibe zumindest von einer Seite vollständig ab. Eine optische Prüfung der gehaltenen Halbleiterscheibe ist demgemäß auch nur von einer Seite möglich. Hier schafft die Erfindung Abhilfe, denn die Stützarme 8 decken die zu haltende Halbleiterscheibe 2 in der Praxis nur zu etwa 20% ab, so dass etwa 80% der Rückseite der gehaltenen Halbleiterscheibe 2 einer visuellen Überprüfung unterzogen werden können.

Diese filigrane Ausführung der Haltevorrichtung 1 hat den weiteren erheblichen Vorteil, dass ihre Masse deutlich geringer ist, als die mit einer geschlossenen Düsenplatte gemäß dem Stand der Technik. Die Handhabung durch das Bedienungspersonal ist dadurch natürlich wesentlich verbessert, was zu weniger Ausschuss und kürzeren Handlingzeiten führt.

Wie auch aus den Figuren 4 und 5 ersichtlich ist, hat die Haltevorrichtung 1 zwei Medien-Anschlüsse, einen Gasanschluss 16 für ausströmendes Gas zur Erzeugung des Bernoulli-Effekts und einen zweiten, den Vakuumanschluss 17, zum Absaugen von Luft, also für die Erzeugung von Vakuum in der Aufnahmevorrichtung 4. Die gezeigte Vorrichtung ist bevorzugt zweiteilig ausgeführt, und zwar besteht sie aus der eigentlichen Haltevorrichtung 1 mit dem Träger 11 für die Aufnahmevorrichtung 4 und einem Handgriff 18, die zusammensteckbar sind. Im Handgriff 18 befindet sich ein als Steuerventil 14 arbeitender Umschalter, mit dem die Quelle und Menge des jeweils ausgewählten Mediums mittels eines Druckknopfs 15 gesteuert werden kann. Diese Bauform erweist sich als vorteilhaft, weil dann unterschiedliche Haltevorrichtungen 1 an den Handgriff 18 angesteckt werden können. Gleichzeitig mit der mechanischen Verbindung von Haltevorrichtung 1 und Handgriff 18 werden die Medien-Anschlüsse 16 und 17 für "Bernoulli-Gas" und "Vakuum" jeweils miteinander verbunden.

In Figur 4 ist eine Variante einer Haltevorrichtung 1 dargestellt. Gleiche Bezugszeichen deuten auf funktionsgleiche Elemente hin. Zur Vermeidung von Wiederholungen wird nur auf die Unterschiede zum Ausführungsbeispiel gemäß Figur 3 eingegangen. Die Haltevorrichtung 1 ist ähnlich wie die gemäß Figur 1 ausgebildet und trägt im Zentrum 3 sowohl Düsenbohrungen 5 als auch eine Ansaugbohrung 6a. Die Stützarme 8 enden in ballig geformten kreisförmigen Aufnahmekuppen 83, auf denen der Außenbereich der Halbleiterscheibe 2 mit geringstem Druck punktuell gerade so aufliegt, dass Planheit gegeben ist und ein Schwingen vermieden wird. Da hier erstmals eine Halbleiterscheibe 2 angedeutet wird, lässt sich auch gut die Abflachung F (Flater)am Umfang 2a der Halbleiterscheibe 2 erkennen, um deren exakte Ausrichtung beim Drehen der Aufnahmevorrichtung 4 es bei der Erfindung geht.

In Figur 4 ist eine Variante der Ausführungsform nach Figur 4 dargestellt. Hier sind die Endbereiche der Stützarme 8 als kreisringförmige Abschnitte 84 ausgebildet, die etwas mehr Auflage für die Halbleiterscheibe 2 bieten, was in einigen Fällen vorteilhaft sein kann. Durch gestrichelte Linien ist angedeutet, dass die kreisringförmigen Abschnitte 84 Teile eines geschlossenen Ringes 22 sein können, der seinerseits Ansaugöffnungen 23 aufweist. Dieser Ring 22 stabilisiert die Haltevorrichtung 1, erhöht dessen Masse aber nur unwesentlich und die visuelle Prüfbarkeit der gehaltenen Oberflächenseite der Halbleiterscheibe 2 verringert sich auch nur unwesentlich.

Es soll auch eine Ausführungsform nicht ausgeschlossen werden, bei der außerhalb der Aufnahmekuppen 8, 83, 84 zumindest Teilbereiche der Stützarme 8 in Form von Erhöhungen so ausgebildet sind, dass die Halbleiterscheibe 2 partiell abgestützt ist. Diese Ausführungsform ist jedoch nicht extra zeichnerisch dargestellt.

## Patentansprüche

1. Vorrichtung zum Handhaben von Platten, insbesondere zum Handhaben von Halbleiterscheiben mit einer pneumatisch arbeitenden Haltevorrichtung zum hydrodynamischen Halten der Halbleiterscheibe, wobei die Haltevorrichtung über ein Zentrum verfügt, welches zumindest Düsenbohrungen zum Erzeugen eines hydrodynamischen Unterdrucks aufweist, **dadurch gekennzeichnet, dass** das Zentrum (3) von einer Aufnahmevorrichtung (4) gebildet wird, welche um ihre Mittelachse drehbar in der Haltevorrichtung (1) gelagert ist.

2. Vorrichtung nach Anspruch 1, **dadurch gekennzeichnet, dass** das Zentrum (3) von einer Aufnahmevorrichtung (4) gebildet wird, deren Drehung mittels eines Antriebs (9, 10, 12, 13) erfolgt.

3. Vorrichtung nach Anspruch 2, **dadurch gekennzeichnet, dass** der Antrieb als Seilrollenantrieb (9, 10, 12, 13) ausgebildet ist.

4. Vorrichtung nach Anspruch 3, **dadurch gekennzeichnet, dass** der Seilrollenantrieb (9, 10, 12, 13) durch ein Handrad (7) manuell betätigbar ist.

5. Vorrichtung nach Anspruch 2, **dadurch gekennzeichnet, dass** der Antrieb als fluidischer Antrieb ausgebildet ist.

6. Vorrichtung nach Anspruch 5, **dadurch gekennzeichnet, dass** der fluidische Antrieb von einem Handrad steuerbar ist.

7. Vorrichtung nach Anspruch 2, **dadurch gekennzeichnet, dass** der Antrieb als elektrischer Antrieb ausgebildet ist.

8. Vorrichtung nach Anspruch 7, **dadurch gekennzeichnet, dass** der elektrische Antrieb von einem Handrad steuerbar ist.

9. Vorrichtung nach Anspruch 1, **dadurch gekennzeichnet, dass** die Aufnahmevorrichtung (3) sternförmig nach außen weisende Stützarme (8) aufweist, welche die zu handhabende Halbleiterscheibe (2) zumindest in deren Außenbereich (2a) abstützen, und dass zwischen den sternförmig nach außen weisenden Stützarme (8) Freiflächen vorhanden sind.

10. Vorrichtung nach Anspruch 1, **dadurch gekennzeichnet, dass** die Aufnahmevorrichtung (1) in ihrem Zentrum (3) über eine zusätzliche Bohrung (6a) zum Ansaugen der Halbleiterplatte (2) verfügt.

11. Vorrichtung nach Anspruch 9, **dadurch gekennzeichnet, dass** die Aufnahmevorrichtung (1) an den Endbereichen ihrer Stützarme (8) Aufnahmekuppen (6b, 83, 84) aufweist.

12. Vorrichtung nach Anspruch 11, **dadurch gekennzeichnet, dass** die Aufnahmevorrichtung (1) in den Aufnahmekuppen (6b) Bohrungen (6a) zum Ansaugen der Halbleiterscheibe (2) aufweisen.

13. Vorrichtung nach Anspruch 11, **dadurch gekennzeichnet, dass** die Aufnahmekuppen (6b, 83) der Aufnahmevorrichtung (1) kreisförmig und ballig ausgebildet sind.

14. Vorrichtung nach Anspruch 11, **dadurch gekennzeichnet, dass** die Aufnahmekuppen der Aufnahmevorrichtung (1) durch kreisringförmige Abschnitte (84) gebildet werden, welche eine konvexe Oberflächengestaltung aufweisen.

15. Vorrichtung nach Anspruch 9, **dadurch gekennzeichnet, dass** die Stützarme (8) an ihren Endbereichen (84) mittels eines Ringes (22) miteinander verbunden sind.

16. Vorrichtung nach Anspruch 15, **dadurch gekennzeichnet, dass** im Ring (22) Ansaugöffnungen (23) angeordnet sind.

17. Vorrichtung nach Anspruch 9, **dadurch gekennzeichnet, dass** an den Stützarmen (8) außerhalb der Endbereiche (6b, 83, 84) Stützelemente für die Halbleiterscheibe (2) vorgesehen sind.

18. Vorrichtung nach Anspruch 1, **dadurch gekennzeichnet, dass** die Aufnahmevorrichtung (1)über einen Handgriff (18) verfügt, durch welchen die Anschlüsse(16, 17) für die Gasversorgung und das Vakuum geführt werden.

19. Vorrichtung nach Anspruch 1, **dadurch gekennzeichnet, dass** die Aufnahmevorrichtung (1) und der Handgriff (18) trennbar ausgeführt sind.

20. Vorrichtung nach Anspruch 1, **dadurch gekennzeichnet, dass** ein Druckknopf (15) vorgesehen ist, der Ventil (14) derart beaufschlagt, dass bei einer einmaliger Druckknopfbetätigung die Vakuumposition aktiviert ist, bei nochmaliger Betätigung das Vakuum abgeschaltet und der Druckknopf (15) wieder in der Ausgangsposition ist.

## Claims

1. Apparatus for board handling, in particular for handling semiconductor wafers using a pneumatically operating holding apparatus for hydrodynamically holding the semiconductor wafer, with the holding apparatus having a centre which has at least nozzle holes in order to produce a hydrodynamic reduced pressure, **characterized in that** the centre (3) is formed by a retaining apparatus (4) which is mounted in the holding apparatus (1) such that it can rotate about its centre axis.

2. Apparatus according to Claim 1, **characterized in that** the centre (3) is formed by a retaining apparatus (4) which is rotated by means of a drive (9, 10, 12, 13).

3. Apparatus according to Claim 2, **characterized in that** the drive is in the form of a cable roller drive (9, 10, 12, 13).

4. Apparatus according to Claim 3, **characterized in that** the cable roller drive (9, 10, 12, 13) can be operated manually by a handwheel (7).

5. Apparatus according to Claim 2, **characterized in that** the drive is in the form of a fluid drive.

6. Apparatus according to Claim 5, **characterized in that** the fluid drive can be controlled by a handwheel.

7. Apparatus according to Claim 2, **characterized in that** the drive is in the form of an electrical drive.

8. Apparatus according to Claim 7, **characterized in that** the electrical drive can be controlled by a handwheel.

9. Apparatus according to Claim 1, **characterized in that** the retaining apparatus (3) has supporting arms (8) which point outwards in the form of a star and support the semiconductor wafer (2) to be handled, at least in its outer area (2a), and **in that** free surfaces are provided between the supporting arms (8) which point outwards in the form of a star.

10. Apparatus according to Claim 1, **characterized in that** the retaining apparatus (1) has an additional hole (6a) at its centre (3), for applying suction to the semiconductor board (2).

11. Apparatus according to Claim 9, **characterized in that** the retaining apparatus (1) has retaining combs (6b, 83, 84) adjacent to the end areas of its supporting arms (8).

12. Apparatus according to Claim 11, **characterized in that** the retaining apparatus (1) has holes (6a) in the retaining combs (6b), for applying suction to the semiconductor wafer (2).

13. Apparatus according to Claim 11, **characterized in that** the retaining combs (6b, 83) of the retaining apparatus (1) are circular and spherical.

14. Apparatus according to Claim 11, **characterized in that** the retaining combs of the retaining apparatus (1) are formed by sections (84) which are in the form of circular rings and have a convex surface shape.

15. Apparatus according to Claim 9, **characterized in that** the supporting arms (8) are connected to one another by means of a ring (22) at their end areas (84).

16. Apparatus according to Claim 15, **characterized in that** suction openings (23) are arranged in the ring (22).

17. Apparatus according to Claim 9, **characterized in that** supporting elements for the semiconductor wafer (2) are provided on the supporting arms (8), away from the end areas (6b, 83, 84).

18. Apparatus according to Claim 1, **characterized in that** the retaining apparatus (1) has a handle (18) through which the connections (16, 17) for the gas supply and the vacuum are passed.

19. Apparatus according to Claim 1, **characterized in that** the retaining apparatus (1) and the handle (18) are designed such that they can be separated.

20. Apparatus according to Claim 1, **characterized in that** a pushbutton (15) is provided and acts on the valve (14) such that the vacuum position is activated when the pushbutton is operated once, and the vacuum is switched off and the pushbutton (15) is returned to the initial position when it is operated again.

## Revendications

1. Dispositif de manipulation de plaques, notamment de manipulation de tranches de semi-conducteurs, comprenant un dispositif de maintien fonctionnant pneumatiquement pour maintenir hydrodynamiquement la tranche de semi-conducteur, le dispositif de maintien disposant d'un centre qui a au moins des trous de buses pour produire une dépression hydrodynamique, **caractérisé en ce que** le centre ( 3 ) est formé par un dispositif ( 4 ) de réception, qui est monté tournant autour de son axe médian dans le dispositif ( 1 ) de maintien.

2. Dispositif suivant la revendication 1, **caractérisé en ce que** le centre ( 3 ) est formé par un dispositif ( 4 ) de réception, dont la rotation s'effectue au moyen d'un entraînement ( 9, 10, 12, 13 ).

3. Dispositif suivant la revendication 2, **caractérisé en ce que** l'entraînement est constitué sous la forme d'un entraînement ( 9, 10, 12, 13 ) à poulie et câble.

4. Dispositif suivant la revendication 3, **caractérisé en ce que** l'entraînement ( 9, 10, 12, 13 ) à poulie et câble peut être actionné manuellement par un volant ( 7 ).

5. Dispositif suivant la revendication 2, **caractérisé en ce que** l'entraînement est constitué sous la forme d'un entraînement fluidique.

6. Dispositif suivant la revendication 5, **caractérisé en ce que** l'entraînement fluidique peut être commandé par un volant.

7. Dispositif suivant la revendication 2, **caractérisé en ce que** l'entraînement est constitué sous la forme d'un entraînement électrique.

8. Dispositif suivant la revendication 7, **caractérisé en ce que** l'entraînement électrique peut être commandé par un volant.

9. Dispositif suivant la revendication 1, **caractérisé en ce que** le dispositif ( 3 ) de réception a des bras ( 8 ) d'appui, qui pointent vers l'extérieur en forme d'étoile et qui soutiennent la tranche ( 2 ) de semi-conducteur à manipuler au moins dans sa partie ( 2a ) extérieure et **en ce qu'**il y a des surfaces libres entre les bras ( 8 ) d'appui pointant vers l'extérieur en forme d'étoile.

10. Dispositif suivant la revendication 1, **caractérisé en ce que** le dispositif ( 1 ) de réception dispose en son centre d'un trou ( 6a ) supplémentaire d'aspiration de la tranche ( 2 ) de semi-conducteur.

11. Dispositif suivant la revendication 9, **caractérisé en ce que** le dispositif ( 1 ) de réception a des coupelles ( 6b, 83, 84 ) de réception aux parties d'extrémité de ses bras ( 8 ) d'appui.

12. Dispositif suivant la revendication 11, **caractérisé en ce que** le dispositif ( 1 ) de réception a dans les coupelles ( 6b ) de réception des trous ( 6a ) d'aspiration de la tranche ( 2 ) de semi-conducteur.

13. Dispositif suivant la revendication 11, **caractérisé en ce que** les coupelles ( 6b, 83 ) de réception du dispositif ( 1 ) de réception sont circulaires et bombées.

14. Dispositif suivant la revendication 11, **caractérisé en ce que** les coupelles de réception du dispositif ( 1 ) de réception sont formées par des parties ( 84 ) en forme d'anneaux de cercle, qui ont une conformation de surface convexe.

15. Dispositif suivant la revendication 9, **caractérisé en ce que** les bras ( 8 ) d'appui sont reliés entre eux à leurs parties ( 84 ) d'extrémité au moyen d'un anneau ( 22 ).

16. Dispositif suivant la revendication 15, **caractérisé en ce que** des ouvertures ( 23 ) d'aspiration sont disposées dans l'anneau ( 22 ).

17. Dispositif suivant la revendication 9, **caractérisé en ce que** des éléments d'appui de la tranche ( 2 ) de semi-conducteur sont prévus sur les bras ( 8 ) d'appui à l'extérieur des parties ( 6b, 83, 84 ) d'extrémité.

18. Dispositif suivant la revendication 1, **caractérisé en ce que** le dispositif ( 1 ) de réception dispose d'une poignée ( 18 ) par laquelle passent les raccords ( 16, 17 ) d'alimentation en gaz et pour le vide.

19. Dispositif suivant la revendication 1, **caractérisé en ce que** le dispositif ( 1 ) de réception et la poignée ( 18 ) sont réalisés de manière à pouvoir être séparés.

20. Dispositif suivant la revendication 1, **caractérisé en ce qu'**il est prévu un bouton poussoir ( 15 ) qui commande la vanne ( 14 ), de façon à ce qu'en actionnant une fois le bouton poussoir on active la position de vide et en l'actionnant encore une fois, on interrompt le vide et on ramène le bouton poussoir ( 15 ) dans la position initiale.
